# EUROPEAN PATENT APPLICATION

(11) **EP 1 727 239 A1**
(43) Date of publication of application: **29.11.2006**
(21) Application number: 06252660.3
(22) Date of filing: 22.05.2006
(51) Int. Cl.: H01Q 15/14, H01Q 15/16

(54) **Reflective surface for deployabe reflector**

(30) Priority: 25.05.2005 US 137186
(71) Applicant: Northrop Grumman Corporation, Los Angeles, CA 90067 (US)
(72) Inventor: Marks, Geoffrey Willilam, Santa Barbara California 93108 (US)
(74) Representative: Naismith, Robert Stewart

(57) **Abstract**

A radio frequency reflective film includes a radio frequency reflective mesh, a plurality of carbon nano-structure materials, and an elastomer. The elastomer encapsulates the radio frequency reflective mesh and the carbon nano-structure materials.

## Description

### TECHNICAL FIELD

The present invention relates to a deployable reflector and, more particularly, to a reflective surface for a deployable reflector that is suitable for higher radio frequencies.

### BACKGROUND

Deployable reflectors are commonly used for radio antennas and solar collectors in terrestrial and space based applications. Typical deployable reflectors include a foldable framework that can support a reflective surface. A variety of structures have been developed for such foldable framework systems. Reflective surfaces are conventionally mounted to these structural supports.

Mesh materials have been used for radio frequency reflective surfaces in terrestrial and space based applications. The mesh material can comprise a variety of materials, such as metal plated wire, polyesters, fiberglass, and fibrous metal materials, that are woven or knit. The woven or knit mesh materials are generally flexible and can be readily stretched over a support structure, such as a rib or other type of structure, which has a parabolic disc shape.

Mesh materials, however, are not suitable for all reflector applications. When tensioned by the support structure, a conventional mesh material will define interstices or spaces between the fibers or filaments forming the mesh. These interstices can degrade the performance of the reflective surface and limit the usefulness of a conventional mesh material to radio frequencies up to about 40 Ghz.

### SUMMARY OF THE INVENTION

The present invention relates to a reflector that can be readily deployed in space based (i.e., extraterrestrial) applications. The reflector includes a light-weight stretchable reflective film that can be readily packed into a relatively small volume prior to deployment. The stretchable radio frequency (RF) reflective film comprises a composite that includes a radio frequency (RF) reflective mesh, a plurality of carbon nano-structure materials, and an elastomer. The elastomer encapsulates the RF reflective mesh and the carbon nano-structure materials to form a uniform continuous surface that defines a radio frequency (RF) reflective surface of the reflector.

In an aspect of the invention, the RF reflective mesh can comprise a radio frequency (RF) reflective fabric that is formed from a conductive fiber (e.g., knit fabric) or plurality of conductive fibers (e.g., woven fabric). The conductive fibers of the RF reflective fabric can have a metallic surface that comprises a high reflective and/or conductive metal, such as gold, silver, copper, aluminum, molybdenum, tungsten, or an alloy thereof.

In another aspect of the invention, the carbon nano-structure materials can be substantially uniformly dispersed in the RF reflective film and be provided in an amount that is effective to substantially fill holes or interstices in the RF reflective mesh so as to make a substantially continuous conductive layer. This amount can be that amount which is effective to increase the electrical conductivity and the RF reflectivity of the RF reflective film.

In a further aspect of the invention, the elastomer can comprise any elastomer that is suitable for space based applications, readily binds to the RF reflective mesh, and remains flexible at temperatures down to about -100°C. Such an elastomer can include a silicone based rubber that is resistant to radiation degradation, microcracking during thermal cycling, and exhibits low outgassing characteristics.

### BRIEF DESCRIPTION OF THE DRAWINGS

Further features of the present invention will become apparent to those skilled in the art to which the present invention relates from reading the following description of the invention with reference to the accompanying drawings.

Fig. 1 illustrates a schematic view of a radio frequency reflective film accordance with an aspect of the invention.

Fig. 2 illustrates an enlarged schematic view of RF reflective film in accordance with an aspect of the invention.

Fig. 3 illustrates a cross-sectional view of the RF reflective film of Fig. 2.

Fig. 4 illustrates a cross-sectional view of conductive fiber that forms a radio frequency reflective mesh in accordance with an aspect of the invention.

Fig. 5 illustrates a schematic flow diagram of a method of forming the RF reflective film in accordance with an aspect of the invention.

Fig. 6 illustrates a schematic perspective view of a deployable RF reflective assembly for a space based application employing the RF reflective film in accordance with an aspect of the invention.

### DETAILED DESCRIPTION

The present invention relates to a reflector that can be readily deployed in space based (i.e., extraterrestrial) applications. The reflector includes a light-weight stretchable (and flexible) radio frequency (RF) reflective film. The RF reflective film can be used to reflect radio frequency bands or energies as high as about 40 Ghz to about 60 Ghz. The reflective film can be readily packaged in a relatively small volume prior to being deployed. The reflective film can also be stretched by a support structure upon deployment to provide a RF reflective surface of the reflector.

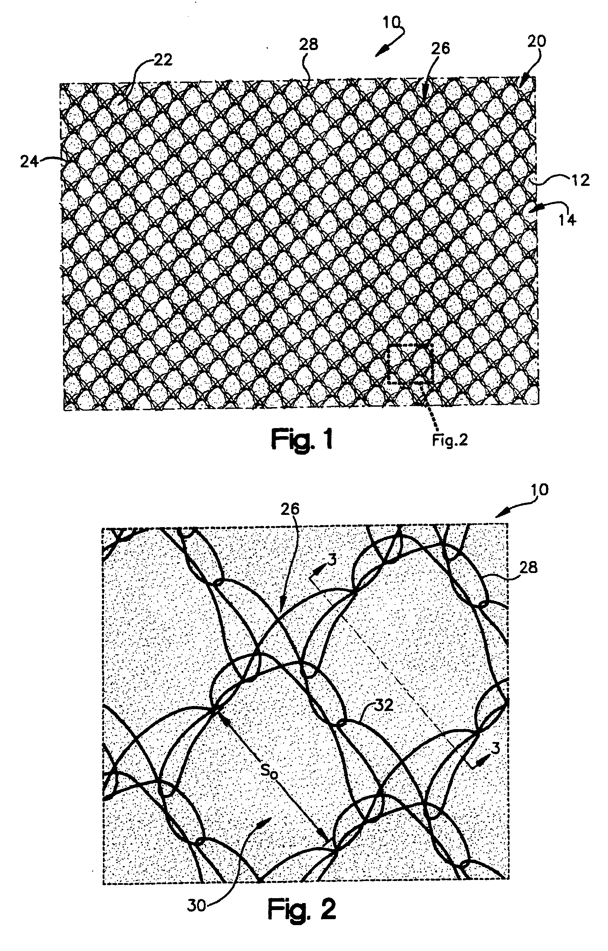

Figs. 1-3 illustrate a stretchable reflective film 10 in accordance with an aspect of the present invention. Referring to Fig. 1, the reflective film 10 comprises a composite 12 that has a continuous solid surface 14. By continuous solid surface 14, it is meant that the reflective film has a solid surface that is substantially free of interstices, voids, holes, spaces and/or gaps, such as those found in woven or knitted meshes. The continuous solid surface of the RF reflective film defines the RF reflective surface of the reflector.

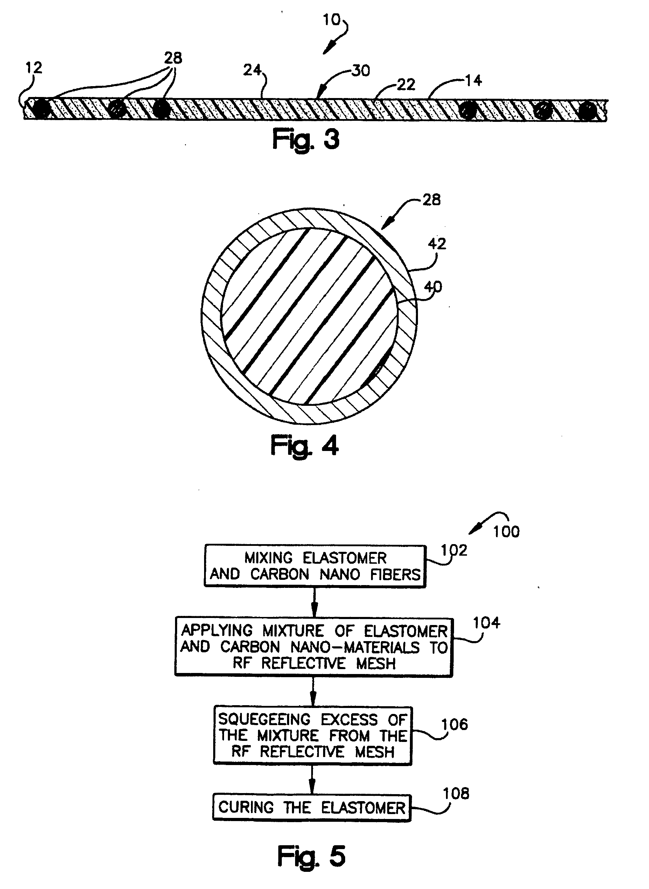

Referring also to Figs. 2 and 3, the composite 12 used to form the RF reflective film 10 includes a radio-frequency (RF) reflective mesh 20, a plurality of carbon nano-structure materials 22, and an elastomer 24 that encapsulates the RF reflective mesh 20 and the plurality of carbon nano-structure materials 22. The RF reflective mesh 20 can comprise a flexible RF reflective fabric 26 that is light weight, readily conducts electricity, and has a low coefficient of thermal expansion.

The RF reflective fabric 26 can include a network of conductive fibers 28 having a spacing predetermined by the frequency of RF energy to be reflected. The smaller the spacing between the conductive fibers 28, i.e., the tighter the mesh, the higher the frequency of RF energy that can be reflected by the RF reflective mesh 20. Conversely, the greater the spacing between the conductive fibers, the lower the frequency of RF energy that can be reflected by the RF reflective mesh 20.

The conductive fibers 28 can be formed into the RF flexible fabric 26 by, for example, knitting, whipping, braiding, lapping, and/or weaving the conductive fibers 28. Other methods of forming the RF reflective fabric 26 from the conductive fibers 28 can also be used. These other methods can include, for example, non-woven fabric forming methods.

In an aspect of the invention, the fabric can comprise a mesh knit of conductive fibers 28. The mesh knit can be a tricot knit configuration, such as illustrated in Fig. 2 and disclosed in U.S. Patent No. 4,609,923, herein incorporated by reference in its entirety. The knit mesh fabric illustrated in Fig. 2 comprises a plurality of openings 30. Each opening of the knit mesh is defined by multiple loops 32 of the conductive fiber 28. At least one loop 32 is formed by the same conductive fiber 28 folded back upon itself, such that relative displacement between loops of conductive fibers at different portions of the mesh knit is permitted. This enables loops 32 at relatively different portions of the mesh knit to pass one another and enter open regions of the mesh knit, so as to be effectively mechanically displaceable with respect to one another in the contour of the mesh knit in response to environmental conditions.

The opening size of the mesh knit, i.e., spacing So between loops 32 of the conductive fibers 28, may lie within a range of about 2 to about 70 per inch (e.g. about 20 per inch). The RF reflective fabric 26 when knit to have a minimal spacing between the conductive fibers 28 can effectively reflect RF energy up to about 40 Ghz.

In another aspect of the invention the flexible RF reflective fabric 26 can be woven from the conductive fibers in, for example, a triaxial woven configuration (not shown), such as disclosed in U.S. Patent No. 6,154,185, herein incorporated by reference in its entirety. The triaxial woven fabric can comprise a plurality of conductive fiber wefts arranged in parallel to each other in a first direction, a plurality of conductive fiber first warps arranged in parallel to each other and intersecting the wefts at about 30 degree angle, and a plurality of conductive fiber second warps arranged parallel and extending orthogonal to the first warp yarns and intersecting the wefts at an about 30 degree angle.

It will be appreciated that the RF reflective fabric 26 can be knit or woven in other knit or weave patterns (e.g., Marquisette, Leno, or basket type weave). These knit or weave patterns can include those commonly used to form RF reflective meshes for space-based applications. It will also be appreciated that the RF reflective fabric 26 can be provided in other non-woven fabric configurations commonly used for RF reflective meshes employed in space-based applications.

The conductive fibers 28 used to form the RF reflective fabric 26 can have an average diameter of, for example, 5 µm to about 150 µm. For example, the conductive fibers 28 can have an average diameter of about 25 µm to about 100 µm mils. The conductive fibers 28 can be made of and/or plated with an electrically conductive metal. The electrically conductive metal can include, for example, platinum, silver, gold, molybdenum, tungsten, nickel, or an alloy thereof. In an aspect of the invention, as illustrated in Fig. 4, the conductive fiber 28 can include a central core 40 and an outer conductive layer 42. The central core 40 can include a conductive metal, such as tungsten or molybdenum, or a light-weight non-metal material, such as a polymer (e.g., nylon, KEVLAR, and DACRON) or a dielectric (e.g., fiberglass). The outer conductive layer 42 can comprise a conductive metal, such as gold, platinum, silver, or an alloy thereof. The diameter of the central core 40 can be, for example, about 25 µm to about 100 µm, and the outer conductive layer 42 can be about 0.10 µm to about 5 µm.

It will be appreciated that the diameter of conductive fibers 28 can be greater or smaller than about 5 µm to about 150 µm depending on the specific RF reflective fabric. It will also be appreciated that the diameters of the individual conductive fibers 28 in the RF reflective fabric 26 need not be uniform but can vary from fiber to fiber.

The carbon nano-structure materials 22 that are employed in the RF reflective film 10 of the present invention can include any electrically conductive carbon nano-scale materials, such as electrically conductive carbon nanofibers, carbon nanowhiskers, vapor grown carbon nanofibers, carbon nanofibrils, carbon nanotubes as well as any other electrically conductive strands or structures of carbon and/or graphite based nano-structure material. Typically, such other electrically conductive strands or structures of carbon and/or graphite based nano-structure material can have a length to diameter ratio greater than about 4, typically greater than about 8, and a mean average diameter less than about 1000 nm (less than about 1000x10⁻⁹ meters). The length to diameter ratio of carbon nano-structure materials can be much higher, for example, greater than about 100 or more.

The electrically conductive carbon nano-structure materials (e.g., carbon nanofibers) can have at least one dimension (e.g., diameter) less than about 500 nm, for example, less than about 300 nm. Desirably, the carbon nano-structure materials have at least one dimension between about 50 nm and about 300 nm (e.g., mean average diameter between about 50 nm and about 300 nm), typically between about 50 and about 250 nm. The carbon nano-structure materials can also have a BET surface area between about 15 and about 50 m²/g, typically between about 15 and about 30 m²/g.

An example of a carbon nano-structure material that can be used in the RF reflective film 10 is a vapor grown carbon nanofiber available under the trade designation PR19HT carbon fibers from Applied Sciences, Cedarville, Ohio. Such carbon nanofibers can be made by methods described, for example, in Applied Sciences U.S. Patent Nos. 6,156,256; 5,846,509; and 5,594,060, herein incorporated by reference in their entirety. In the methods disclosed in these patents, hydrocarbons, such as methane, are pyrolyzed in a gas phase reaction at temperatures of about 1000°C or higher. The gas phase reaction involving the hydrocarbon can be carried out upon contact with metal particles, typically iron particles in a nonoxidizing gas stream. The iron particles catalyze the growth of very thin individual carbon fibers (e.g., carbon nanofibers), which have a graphitic carbon structure. The resulting carbon nanofibers can have a very thin diameter (nanofibers), for example, between about 50 nm and about 300 nm. The resulting carbon nanofibers have a graphitic carbon structure as defined in International Committee for Characterization and Terminology of Carbon (ICCTC, 1982), published in the Journal Carbon, Vol. 20, p. 445.

The carbon nano-structure materials 22 can be substantially uniformly dispersed in the RF reflective film 10. The carbon nano-structure materials 22 can also be provided in an amount that is effective to substantially fill holes or interstices in the mesh 26 so as to provide a continuous conductive layer that is defined by the RF reflective mesh and the carbon nano-structure materials. The amount of carbon nano-structure materials 22 provided in the RF reflective film can be that amount, which is effective to increase the electrical conductivity and the RF reflectivity of the film. In an aspect of the invention, this amount can be an amount effective to provide the film with a suitable RF reflectivity at radio frequency bands (or energies) of about 40 Ghz to about 60 Ghz. This amount can vary depending on the particular conductive fiber 28 used to form the RF reflective mesh and the fabric configuration of the RF reflective mesh 20 (e.g., the number of openings provided in the RF reflective mesh). By way of example, the amount of carbon nano-structure material provided in the conductive film can be about 1% to about 20% by weight of the RF reflective film, and, more particularly, about 3% to about 15% by weight of the RF reflective film.

The elastomer 24 that encapsulates the RF reflective mesh 20 and the plurality of uniformly dispersed carbon nano-structure materials 22 can comprise any elastomer that is suitable for space-based applications, readily binds to the RF reflective mesh 20, remains flexible at temperatures down to about -100°C, and does not substantially impair the reflectivity of the RF reflective mesh. One example of such an elastomer is a silicone based rubber that is resistant to radiation degradation, microcracking during thermal cycling (e.g., about -100°C to about 100°C), and exhibit low outgassing characteristics. Silicone based rubbers that are resistant to radiation degradation, microcracking, and outgassing will generally employ during formulation a minimal amount of volatiles, such as low molecular weight polydimethylsiloxanes and low outgassing fillers and curing agents. Exemplary silicone based rubbers that can be employed for spaced applications include silicone based rubbers commercially available from Arlon Silicone Technologies under the tradename Thermabond. Other silicone based rubbers can be selected from silicone rubbers produced by GE SILICONES, Waterford, NY. Still other silicone based rubbers that are suitable for space based applications can be readily identified from publications, such as Campbell et al. NASA Reference Publication 1124, Revision 3, November 1990.

The silicone based rubber can be provided in an amount that is effective to encapsulate the RF reflective mesh 20 and the carbon nano-structure materials 22 and provide a continuous uniform surface on the RF reflective film 10. This amount can vary depending on the specific silicone based rubber used as well as the weight percentage of the carbon nanofiber and the type of RF reflective mesh 20 employed in the RF reflective film 10. By way of example, this amount can be from about 5% to more than about 20% by weight of the composite.

It will be appreciated that other elastomers besides silicone based rubbers that are suitable for space based applications, readily bind to the reflective mesh, and remain flexible at temperatures down to about -100°C can be used in accordance with present invention. These other elastomers can be based on fluorinated rubbers, epoxies, and polyurethane elastomers.

Optionally, the composite that forms the RF reflective film 10 can include additives. These other additives can include materials, besides the carbon nano-structure materials, which can potentially improve the conductivity of the RF reflective film, elastomer processing aids, such as plasticizers, curing agents and stabilizers, as well as materials that can mitigate products of intermodulation. The additives can be provided, for example, in amounts up to about 5% by weight of the composite.

The RF reflective film 10 formed from the composite of the RF reflective mesh 20, the carbon nano-structure materials 22, and the elastomer 24 can have a thickness that allows the RF reflective film to be readily flexed and stored prior to deployment. The thickness can be, for example, from about 50 µm to about 150 µm. In an aspect of the invention, this thickness can be about 100 µm or less.

The RF reflective film 10 can be formed by coating the RF reflective mesh 20 with the elastomer 24 and the carbon nano-structure materials 22. Fig. 5 is a schematic flow diagram illustrating one coating method 100 in accordance with an aspect of the invention. In the method at 102, an elastomer suitable for spaced-based applications is mixed with a desired amount of carbon nanofiber using a conventional mixing apparatus, such as a sigma blade mixer. The elastomer can be in the form of a viscous liquid or molten liquid and be either uncured and/or semi-cured. The desired amount of carbon nano-structure materials can be an amount effective to fill the holes of the RF reflective mesh and form a substantially continuous conductive layer when the mixture is applied to the RF reflective mesh. The carbon nano-structure materials are mixed with the elastomer until the carbon nano-structure materials are uniformly dispersed in the elastomer.

At 104, the mixture of the elastomer and the carbon nano-structure materials can be applied to a RF reflective mesh by, for example, pouring, spraying, and/or brushing the mixture onto a surface of the RF reflective mesh. Optionally, the RF reflective mesh can be immersed in the mixture. The mixture applied to the RF reflective mesh substantially fills the holes and/or interstices in the mesh and provides a substantially uniform layer of the mixture on at least one surface of the RF reflective mesh.

At 106, excess of the mixture of elastomer and carbon nano-structure materials applied to the RF reflective mesh can be removed from the surfaces of the RF reflective mesh. The excess mixture can be removed by, for example, wiping a squeegee across the surface of the RF reflective mesh so that RF reflective mesh is provided with a substantially uniform thin layer of the elastomer and carbon nano-structure materials.

At 108, the elastomer provided on the RF reflective mesh is cured to solidify the elastomer and form the stretchable film. The method by which the elastomer is cured depends on the particular elastomer employed. By way of example, where a silicone based rubber is used as the elastomer, the silicone based rubber can be cured by heating the silicone to an elevated temperature (e.g., about 100°C) for a time period effective to the solidify the elastomer. The RF reflective film so formed can have a continuous conductive solid surface and can be used as an RF reflector at frequency bands from about 40 Ghz to about 60 Ghz.

In accordance with an aspect of the invention, the RF reflective film can be used to provide a RF reflective surface for a reflector antenna. Particularly, the RF reflective film can be used to provide a RF reflective surface of a large aperture, light weight reflector antenna that can be compactly stowed during transportation and delivery and deployed in space.

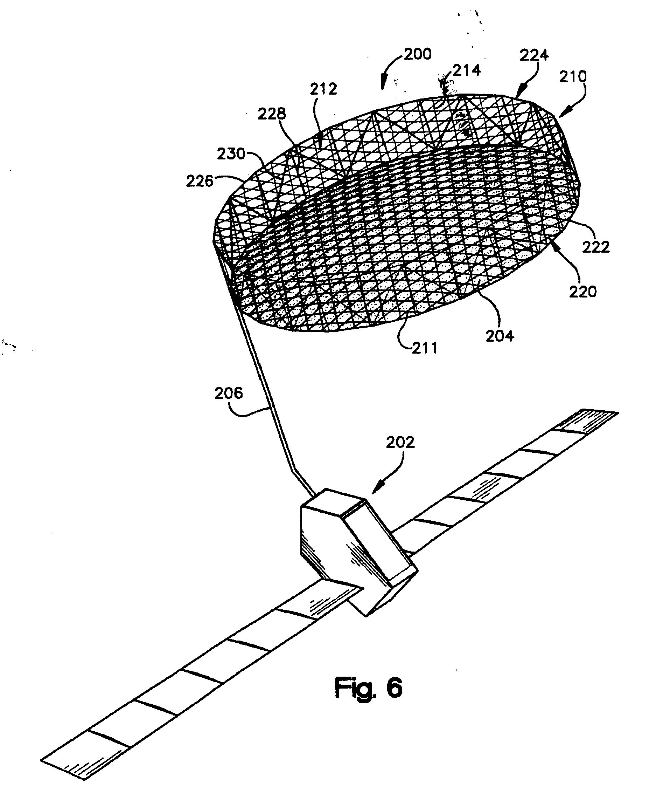

Fig. 6 illustrates an example of a large aperture light-weight reflector antenna 200 of a space craft or satellite 202 employing the RF reflective film 204 in accordance with the present invention. The reflector antenna 200 is connected by an arm or boom 206 to the spacecraft or satellite body 202.

The reflector antenna 200 includes an outer rim structure 210 that surrounds and supports a first network (or net) 211 and a second network (or net) 212 of non-extensible bands or tapes 214. The rim structure 210 is composed of a front net ring 220 composed of a plurality of longerons 222 and a rear net ring 224 composed of a plurality of longerons 226. A plurality of vertical struts 228 are connected between the front and rear net rings 220 and 224 along with diagonal struts 230. Longerons 222 and 226 and vertical struts 228 are preferably rigid members, which are hinged at their points of connection to permit the reflector antenna 200 to be stowed prior to deployment. Diagonal struts 230 may be telescoping members which extend to a maximum length when the reflector antenna 200 is in the fully deployed state shown in FIG. 6, or may be flexible, inextensible members.

Tension ties (not shown) can be fastened between nets 211 and 212 to apply sufficient tension to the surface of the net 211 to produce a paraboloidal shape in at least net 211. A load is thus applied between the surfaces of the 210 and support nets 211 and 212 so that the convex centers, respectively, of the inverted nets 211 and 212 are close together relative to the outer peripheral area of each net.

It will be recognized that a variety of different methods are available to produce the paraboloidal shape of the reflector net 211. For example, gas pressure may be applied to cause the face of the reflector net 211 to form a concave surface. Electrostatic or hydrostatic tension may also be applied to the rear side of the reflector net 211 to pull the center of the surface into a paraboloidal structure. Another method for forming the paraboloidal net is to use centrifugal loading in which rotation of the net causes the net to become bowed at its center.

The outer rim 210 of the reflector antenna 200 is collapsible for stowage during transportation to the particular site in space where the antenna will be deployed. Likewise, the upper and lower nets 211 and 212 may be folded or rolled into a compact cylindrical package.

The RF reflective film 204 in accordance with the present invention is attached to and supported by the paraboloidal net 211 so that the RF reflective film 204 will have a desired shape (e.g., parabolic). The RF reflective film 204 provides film provides the RF reflective surface of the reflector antenna 200. The RF reflective film 204 can comprise, for example, a gold plated molybdenum knit mesh that is coated with a silicone based rubber and an amount of carbon nano-structure materials effective to provide substantially continuous conductive layer in the RF reflective film 204. The RF reflective film can readily reflect radio frequencies up to about 40 Ghz to about 60 Ghz.

The RF reflective film 204 can be draped sufficiently taut over the paraboloidal net 211 to eliminate wrinkles and creases. Accordingly, the RF reflective film 204 is extensible and tightly stretched across the convex side of the paraboloidal net 211. Since the net 211 is located very close to the RF reflective film 204, incoming and outgoing electromagnetic signals are reflected off the RF reflective film 204 without interference by the net 211. As a result, the reflectivity of the reflector antenna 200 can be maximized to reflect RF energy up to about 40 Ghz to about 60 Ghz.

The reflector antenna 200 including the outer rim 210, net assemblies 211 and 212, and RF reflective film 204 are collapsible for deployment in space. When the spacecraft or satellite 202 is transported into orbit, the reflector antenna 200 is folded into a smaller package. Once the spacecraft 202 is positioned in space, the antenna is unfurled into the shape and position shown in Fig. 6. Because the reflector antenna 200 must be transported to or launched in space and mounted to a variety of spacecraft 202, the overall package size of the collapsed antenna before deployment is significant. Depending upon the particular configuration of the nets and outer rim, the outer rim 210 is preferably packaged with the paraboloidal nets 211 and 212 and RF reflective 204 film attached to the rim as a single deployable unit. The support nets 211 and 212 can be made of sufficiently flexible materials to be spirally rolled within the small cylinder formed inside the collapsed rim 210. The nets 211 and 212 and the RF reflective film 204 may also be folded or otherwise compacted, depending upon the particular materials used.

It will be appreciated by one skilled in the art, that other deployable reflector antenna structures can be used to support the RF reflective film in accordance with the present invention. These other deployable reflector antenna structures can comprise, for example, a plurality of radial ribs that can maintain the stretchable film in a parabolic shape.

From the above description of the invention, those skilled in the art will perceive improvements, changes and modifications. Such improvements, changes and modifications within the skill of the art are intended to be covered by the appended claims.

## Claims

1. A radio frequency reflective film comprising a radio frequency reflective mesh, a plurality of carbon nano-structure materials, and an elastomer, the elastomer encapsulating the radio frequency reflective mesh and the carbon nano-structure materials.

2. The film of claim 1, the radio frequency reflective mesh comprising at least one fiber having a metallic surface, the metallic surface comprising at least one of gold, silver, copper, aluminum, molybdenum, nickel, or an alloy thereof.

3. The film of claim 1, the radio frequency reflective mesh comprising a knit fabric, the knit fabric including at least one conductive fiber, the conductive fiber including at least one of a metal or metal plating selected from group consisting of gold, silver, copper, aluminum, molybdenum, nickel, or an alloy thereof.

4. The film of claim 1, the carbon nano-structure materials being substantially uniformly dispersed in the film.

5. The film of claim 1, the carbon nano-structure materials being provided in an amount effective to increase the electrical conductivity of the film.

6. The film of claim 1, having a thickness up to about 250 microns.

7. The film of claim 1, the elastomer readily binding to the reflective mesh and remaining flexible at temperatures down to about -100°C.

8. The film of claim 1, the elastomer comprising a silicone based rubber.

9. The film of claim 1, the stretchable film being capable of effectively reflecting radio frequencies from about 40 Ghz to about 60 Ghz.

10. A reflector comprising a radio frequency reflective film of claims 1-9.
